# EUROPEAN PATENT APPLICATION

(11) **EP 4 641 329 A1**
(43) Date of publication of application: **29.10.2025**
(21) Application number: 24172724.7
(22) Date of filing: 26.04.2024
(51) Int. Cl.: G05B 19/418, G06F 30/27

(54) **METHOD AND SYSTEM FOR CONTROLLING A PRODUCTION PLANT TO MANUFACTURE A PRODUCT**

(71) Applicant: Siemens Aktiengesellschaft, 80333 München (DE)
(72) Inventor: DEPEWEG, Stefan, 13627 Berlin (DE); HEESCHE, Kai, 81539 München (DE); AMINE-EDDINE, Gabriel, Yateley GU46 6AL (GB)
(74) Representative: Siemens Patent Attorneys

(57) **Abstract**

An appropriately trained machine learning module (BNN) is used for generating a group of predictive performance values (PV) for each design data record (DR) of a first set (S1) of design data records. For the first set (S1), a pareto front (PF1) is determined based on the corresponding groups. In a further step, a first rank is assigned to the design data records (DR) of the pareto front (PF1). Then the design data records of the pareto front (PF1) are removed from the first set (S1), resulting in a reduced set (S2) of design data records. The above steps of determining a pareto front, assigning a rank, and removing design data records of a respective pareto front are repeated with decreasing ranks. Depending on a resulting rank of a respective design data record (DR), a simulation of the design variant corresponding to that design data record (DR) is either run or skipped. Based on an aggregated performance value (APV) derived from the simulation or from the corresponding group of predictive performance values (PV), a performance-optimizing design data record (ODR) is selected from the first set (S1) of design data records. The selected design data record (ODR) is then output for controlling the production plant (PP).

## Description

Nowadays, the production of complex products like e.g., robots, motors, turbines, turbine blades, combustion engines, machining tools, vehicles, or their components often relies on sophisticated design systems. Such design systems usually provide design data which specify the product to be manufactured in detail. By such design data a modern production system can be specifically controlled to manufacture the specified product.

In order to optimize a performance of a product with regard to given objectives, it is often aspired to automatically optimize the design data for the product. Such a performance may pertain to a power, a yield, a speed, a running time, a precision, an error rate, a resource consumption, an efficiency, a pollutant emission, a stability, a wear, a lifetime, and/or other target performance quantities of the product. For the purpose of optimizing the performance, some design systems use so-called multi-disciplinary optimization (MDO) tools. These tools usually simulate design variants of a product as specified by various design data records and look for those design data records which optimize the simulated performance of the product, in particular with regard to several objectives.

Such simulations, however, often consume a high amount of computational resources to determine the target performance quantities for each design variant. To reduce the computing demand, so-called surrogate models, e.g., based on machine learning, may be used to predict the outcome of a simulation. Such surrogate models, however, often have a poor accuracy.

It is an object of the present invention to provide a method and a system for controlling a production plant to manufacture a product, that allow for a more efficient design optimization.

This object is achieved by a method according to patent claim 1, a system according to patent claim 9, a computer program product according to patent claim 10, and a computer readable storage medium according to patent claim 11.

For controlling a production plant to manufacture a product a machine learning module is provided. The machine learning module is trained to generate from a design data record specifying a design variant of the product, a group of predictive performance values each quantifying a different performance quantity of that design variant. The performance quantities may pertain to a power, a yield, an efficiency, a speed, a running time, a precision, an error rate, a tendency to oscillate, a resource consumption, an aerodynamic efficiency, an energy efficiency, a pollutant emission, a stability, a wear, a lifetime, and/or to other target performance quantities of the design variant. Furthermore, a first set of design data records is provided, each specifying a different design variant of the product. From each design data record of the first set a corresponding group of predictive performance values is generated by the machine learning module. Moreover, a pareto front of the first set is determined based on the corresponding groups and with the different performance quantities as target quantities. In a further step a first rank is assigned to the design data records of the pareto front. Then the design data records of the pareto front are removed from the first set, resulting in a reduced set of design data records. The above steps of determining the pareto front, assigning the first rank, and removing the design data records of the pareto front are repeated with the reduced set in place of the first set and with a reduced rank compared to the first rank, until a respective design data record is ranked. Depending on the rank of the respective design data record, a simulation of the design variant corresponding to the respective design data record is either run or skipped. In particular, the simulation may be skipped if the rank of the respective design data record falls below a predetermined threshold. Furthermore, an aggregated performance value is generated for the respective design data record, the aggregated performance value being derived from the simulation if the simulation is run, or otherwise derived from said corresponding group of predictive performance values. Depending on the aggregated performance values, a performance-optimizing design data record is selected from the first set of design data records. The selected design data record is then output for controlling the production plant.

For performing the inventive method, a system, a computer program product, and a non-transient computer readable storage medium are provided.

The inventive method and/or the inventive system may be implemented by means of one or more processors, computers, application specific integrated circuits (ASIC), digital signal processors (DSP), programmable logic controllers (PLC), and/or field-programmable gate arrays (FPGA). Moreover, the inventive method may be executed in a cloud and/or in an edge computing environment.

The invention allows to skip particular expensive simulations in cases where a prediction of the machine learning module indicates that a design variant is likely to perform worse than previously assessed design variants and, therefore, is unlikely to be selected for manufacturing the product. A design variant is likely to perform worse than other design variants if the rank of the corresponding design data record is substantially behind the first rank. In this way, the number of simulations and, therefore, a computational effort may be reduced considerably without significantly overlooking promising design variants. In many cases, the machine learning model can be used as an efficient surrogate model for evaluating the design variants.

Due to the utilization of pareto fronts, several different performance quantities can be taken into account for ranking a respective design variant within the other design variants. This is of particular importance for products having several or many critical design objectives.

The inventive ranking method is particular advantageous over a ranking which is based on a distance of a respective design variant to the next element of the pareto front. In case of the latter ranking method, that distance depends on the density of the elements on the pareto front. At low densities the distance may be quite large, though the respective design variant may be nearly pareto-optimal. Compared to that, the present invention allows a more reliable ranking even in case of inhomogeneously populated design spaces.

Particular embodiments of the invention are specified by the dependent claims.

According to a preferred embodiment of the invention, the machine learning module may comprise or implement a Bayesian machine learning model, a Bayesian neural network, a Gaussian process model and/or another uncertainty-aware machine learning model. For the preceding models, many efficient learning methods are known which allow training the models to generate predictions in the form of predictive values or statistical distributions of such values in a consistent and uniform way. Some pertinent machine learning methods for training uncertainty-aware machine learning models are e.g. described in "Pattern Recognition and Machine Learning" by Christopher M. Bishop, Springer 2011.

Furthermore, in case the simulation of a design variant is run, a group of simulated performance values quantifying the different performance quantities of said design variant may be determined by means of the simulation. The group of simulated performance values may then be used for ranking, in particular re-ranking the corresponding design data record. In many cases the simulated performance values are more accurate than the performance values as predicted by the machine learning module. Accordingly, a ranking based on simulated performance values is expected to be more reliable than a ranking based on predictive performance values.

According to a further embodiment of the invention the machine learning module may generate, together with a respective predictive performance value, a predictive uncertainty of the respective predictive performance value. The predictive uncertainty may then be taken into account when deciding on running or skipping the simulation. In particular, a weighted sum of the rank and the predictive uncertainty may be calculated and compared with a predetermined threshold value. The simulation my then be run if the weighted sum is above a predetermined threshold.

The predictive uncertainty may be particularly represented by a statistical standard deviation, a statistical variance, a discrete probability distribution, a statistical sample, a confidence interval, or an error interval of the respective predictive performance value. Such statistical distributions may be considered as distributions of plausible predictions.

Alternatively or additionally, the respective predictive performance value may be modified depending on the predictive uncertainty. In particular, the respective predictive performance value may be modified by adding the predictive uncertainty, optionally multiplied by an uncertainty scaling factor, to said respective predictive performance value. The pareto front may then be determined based on the modified predictive performance values.

The modification of a respective predictive performance value may provide an upper bound or upper value which is likely to be not exceeded by an actual performance of the corresponding design variant. If the rank of a design data record is based on such upper bounds or upper values and still falls below the first rank, it appears to be unlikely that the corresponding design variant will perform better than other designs variants. Hence, an expensive simulation may be skipped. A likelihood of not exceeding the upper value may be varied by setting an appropriate uncertainty scaling factor, e.g. in the range from 0.5 to 5.

According to a further embodiment of the invention the ranks of the design data records may be normalized to lie between a predefined lower bound, e.g. zero, corresponding to the lowest rank and a predefined upper bound, e.g. one, corresponding to the highest rank, resulting in normalized ranking values.

In particular, the simulation of the design variant corresponding to a respective design data record may be skipped if the normalized ranking value of said respective design data record falls below a predefined threshold value, e.g. in the interval from 0.3 to 0.9.

In general, the number of different ranks depends on the number of different pareto fronts encountered while executing the inventive method. A normalization of the ranks has the advantage that rankings from different sets of design data records may allow a meaningful comparison.

According to a further embodiment of the invention a training of the machine learning module may be continued by using simulated performance values as training data. In this way the predictions of the machine learning module may be improved by using results of the simulation.

Particular embodiments of the invention are described in the following paragraphs with reference to the figures. The figures illustrate in schematic representation:
- Figure 1: a design system controlling a production plant to manufacture a product,
- Figure 2: a design system in a training phase,
- Figures 3-4: a determination of a sequence of pareto fronts for design data records, and
- Figure 5: an optimization of a product design by a design system.

In the figures, common reference signs denote the same or corresponding entities, which are preferably embodied as described at the respective place.

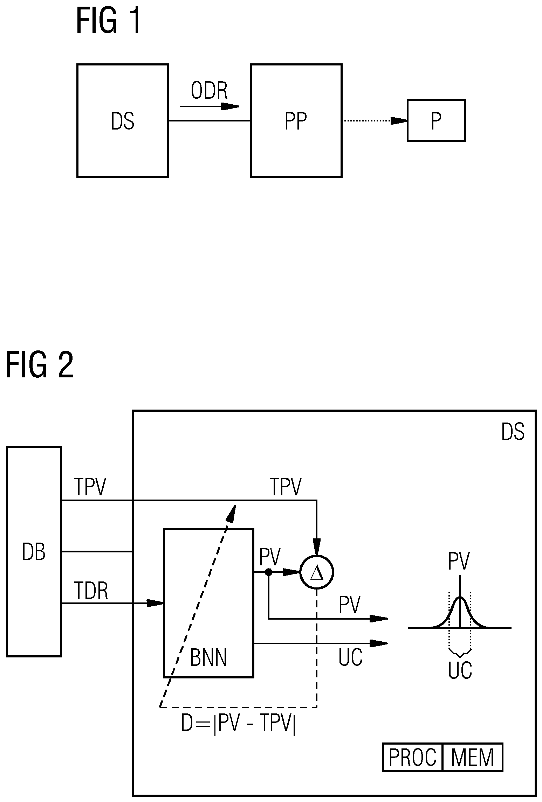

Figure 1 shows in schematic representation, a design system DS coupled to a production plant PP and controlling the production plant PP to manufacture a product P. The production plant PP may be or comprise a manufacturing plant, a robot, a machining tool, and/or other devices for manufacturing or machining products by means of design data. The product P to be manufactured may be a robot, an electrical or electronical device, a motor, a turbine, a turbine blade, a combustion engine, a machining tool, a vehicle, a subproduct, a device, or a component thereof.

A design or design variant of the product P to be manufactured is specified by design data in the form of one or more design data records. In particular, such design data records may specify a geometry, a structure, a property, a production step, a material, a component, and/or a part of the product P.

According to the present embodiment, the design system DS should be enabled to automatically generate design data records ODR which are optimized with regard to several predefined performance objectives for the product P. The predefined performance objectives are aimed at optimizing different performance quantities of the Product P. In that respect, the terms optimization or optimizing should also comprise the meaning of getting closer to an optimum.

Such a performance quantity may be a power, a yield, an efficiency, a speed, a running time, a precision, an error rate, a tendency to oscillate, a resource consumption, an aerodynamic efficiency, an energy efficiency, a pollutant emission, a stability, a wear, a lifetime and/or another target quantity of the product P. Furthermore, the performance quantities may pertain to a fulfillment of predefined constraints by the product P. Such constraints may pertain to geometrical limits, temperature limits, pressure limits, speed limits, electrical limits, force limits, power limits, pollution limits, and/or to other requirements which should be fulfilled by the product P.

The design system DS generates such performance-optimizing design data records ODR and transmits them to the production plant PP. By means of the transmitted design data records ODR, the production plant PP is controlled and manufactures the performance-optimized and constraint-compliant product P as specified by that design data records ODR. For manufacturing products specified by design data, many efficient computer-operated manufacturing tools are available.

Figure 2 illustrates a design system DS in a training phase. The design system DS comprises one or more processors PROC for performing the method steps of the invention and one or more data storages MEM for storing related data.

The design system DS is coupled to a database DB and further comprises a machine learning module BNN, which is implemented as a Bayesian neural network according to the present embodiment. Such a Bayesian neural network can be considered as a statistical estimator, which has an intrinsic capability to automatically estimate realistic uncertainties of its predictions. The Bayesian neural network serves the purpose of determining statistical estimation values for e.g., a mean, a variance, a standard deviation, and/or a probability distribution, from empirical data of a sample of a statistical population. A Bayes estimator may particularly optimize a posterior expected value of a loss function, cost function, reward function, or utility function.

By means of known machine learning methods and using sample data from a statistical population, a Bayesian neural network, here BNN, can be trained to estimate a predictive probability distribution for a given new data record of that statistical population. Additionally, or alternatively to the Bayesian neural network, the machine learning module BNN may comprise or implement a Gaussian process model, which can also be trained to estimate a predictive probability distribution for a given new data record of a statistical population.

A predictive probability distribution may be represented by a predicted mean or median together with its statistical variance or standard deviation. In this case, the variance or standard deviation may be regarded as uncertainty of the mean or median value. Additionally or alternatively, an uncertainty of a predictive probability distribution may be specified by an error interval, a confidence interval, or other measures of a width of that probability distribution. In that sense, a Bayesian neural network and a Gaussian process model can be regarded as uncertainty-aware machine learning models.

Some pertinent machine learning methods for training uncertainty-aware machine learning models are e.g. described in the publication "Pattern Recognition and Machine Learning" by Christopher M. Bishop, Springer 2011.

According to the present embodiment the product P should be optimized with regard to several predefined performance objectives regarding several different performance quantities. Accordingly, the Bayesian neural network BNN should be trained to generate from a design data record specifying a design variant of the product P, for each of the performance quantities an individual predictive performance value quantifying that specific performance quantity of that design variant, together with an uncertainty of the respective predictive performance value.

Here, the term training generally means that a mapping from input data of a machine learning module to output data of that machine learning module is optimized with regard to one or more criteria during a training phase. In the present case, the criteria comprise reproducing statistical distributions of several performance quantities of design variants. The mapping can be optimized by tuning mapping parameters of the machine learning module. In case of artificial neural networks, a connective structure of its neurons and/or weights of connections between the neurons may be varied in order to optimize the mapping. For such optimizations a multitude of numerical standard methods, like e.g. gradient descent methods, particle swarm methods, or genetic algorithms are available.

For training the Bayesian neural network BNN, a large amount of training data stored in the database DB are fed into the design system DS. The training data comprise many training design data records TDR, each specifying a design variant of a product.

Assigned to a respective training design data record TDR, the training data further comprise for each of the performance objectives a corresponding objective-specific performance value TPV quantifying a respective objective-specific performance quantity of the respective design variant.

These performance values TPV may be obtained from performance measurements on previously tested design variants of the product or of similar products. As the development of new products usually involves comprehensive tests of many design variants, appropriate training data bases are available for many product groups.

The training design data records TDR are input to the Bayesian neural network BNN as input data. From a respective training design data record TDR, the Bayesian neural network BNN generates a group of predictive performance values PV, the group comprising for each of the performance quantities an estimated objective-specific predictive performance value quantifying that performance quantity. Furthermore, the Bayesian neural network BNN outputs for each of the objective-specific predictive performance values PV a corresponding objective-specific predictive uncertainty UC of that respective objective-specific predictive performance value.

Here, a respective predictive performance value may be regarded as a statistical mean of a predictive probability distribution and the corresponding uncertainty UC may be regarded as a width of that predictive probability distribution.

Preferably, a respective group of predictive performance values PV may be represented by a first vector comprising the individual performance values of that group PV. Similarly, the corresponding performance values TPV may be combined in a second vector, and the corresponding predictive uncertainties UC may be combined in a third vector. All three vectors are preferably sorted in such a way that a given vector index refers to the same performance quantity in all vectors.

For each training design data record TDR, the corresponding generated group of predicted performance values PV is output by the machine learning module BNN and compared with the corresponding objective-specific performance values TPV. In doing so, a deviation D of the group of predicted performance values PV from the corresponding performance values TPV is fed back to the Bayesian neural network BNN as indicated by a dashed arrow in figure 2. The deviation D may be determined as a vector norm of a difference between a respective first vector representing PV and a corresponding second vector representing TPV, e.g. like D = ∥*PV* - *TPV*∥*.*

By means of that feedback, the Bayesian neural network BNN is trained to minimize, at least on average, the deviation D and to output uncertainties UC which reflect the actual statistics of the training data. In this way a predictive probability distribution of the objective-specific performance values is reproduced by the Bayesian neural network BNN.

After the training, the Bayesian neural network BNN can be used as a statistical estimator. The trained Bayesian neural network BNN is particularly enabled to generate from a design data record specifying a design variant of the product P, for each of the performance objectives a predictive performance value estimating the corresponding performance quantity, and a predictive uncertainty of that estimation.

The predictions of the trained Bayesian neural network BNN can be used for evaluating and optimizing design data records. For taking into account the different performance objectives, a so-called pareto optimization will be performed.

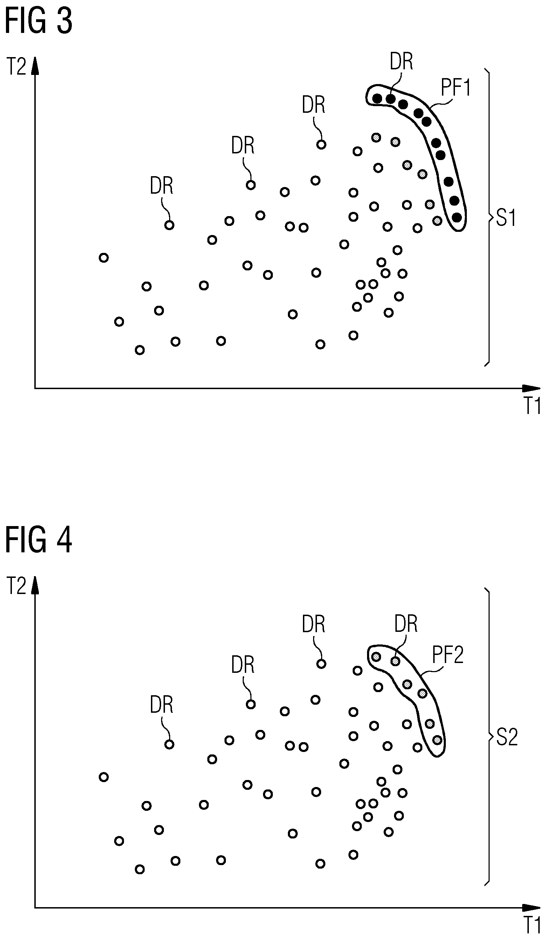

Figures 3 and 4 illustrate in schematic representation a pareto optimization and a successive determination of a sequence of pareto fronts PF1 and PF2 for a variety of design data records DR.

A pareto optimization is a multi-objective optimization, in which several different target quantities can be simultaneously considered. A pareto optimization usually results in a pareto front consisting of pareto optimal points. The pareto optimal points are those solutions of a multi-objective optimization, for which a respective target quantity cannot be improved without worsening or negatively affecting another target quantity. In a sense, a pareto front consists of a set of optimal compromises, here optimal compromises of design variants. Conversely, solutions which are not part of a pareto front can be improved with regard to at least one target quantity without worsening any other target quantity, and therefore, can be considered as being sub-optimal in each case. Usually, such sub-optimal solutions can be ruled out in further optimizations, thus reducing a computational effort.

In the present embodiment, the performance quantities of the predefined performance objectives are used as target quantities. With regard to the figures 3 and 4 it is assumed that objective-specific performance values for all performance objectives are allocated to each of the design data records DR.

In the figures 3 and 4 the design data records DR are plotted into a coordinate system with some exemplary target quantities T1 and T2 as coordinate axes. The design data records DR are located according to their allocated target quantities, i.e., performance values. For the sake of simplicity, only a few of the design data records DR are marked with a reference sign.

In the preset case the pareto optimization is carried out in the direction of increasing target quantities T1 and T2. For performing such pareto optimizations and for determining a respective pareto front, many efficient standard routines are available.

Figure 3 illustrates a determination of a first pareto front PF1 within a first set S1 of design data records DR. The first pareto front PF1 consists of all design data records DR of the first set S1 for which a target quantity T1 or T2, respectively, cannot be improved without worsening or negatively affecting another target quantity T2 or T1, respectively.

The design data records of the first pareto front PF1 may be regarded as most promising design candidates as the other design data records appear sub-optimal. However, due to uncertainties of the predictions of the trained machine learning module BNN, on which the pareto optimization is based, other design data records DR should also be considered, so as not to overlook good but underestimated design candidates.

This is done by successively determining further pareto fronts and assigning a decreasing rank to them. Here, as usual, a rank is considered higher if it has a lower ranking number, i.e. the ranking number 1 is the highest (best) rank. With this in mind, the design data records of the first pareto front PF1 are assigned a first rank 1.

On that basis figure 4 illustrates a determination of a second pareto front PF2. To do this, the design data records of the first pareto front PF1 are removed from the first set S1, resulting in a reduced set S2 of design data records. For the reduced set S2 the pareto optimal points are determined, resulting in the second pareto front PF2. The design data records of the second pareto front PF2 are then assigned a second rank of 2, which is obtained by increasing the previous rank number by 1.

The above procedure of removing, determining, and ranking successive pareto fronts is repeated until each design data record DR is ranked or until another stop criterion is fulfilled. With each successive pareto front the ranking number is increased by 1.

Alternative stop criteria may comprise exceeding a predefined ranking number, exceeding a predefined number of ranked design data records, and/or exceeding a predefined distance to the first pareto front PF1.

In order to allow a meaningful comparison of ranks from different sets of design data records, the resulting ranking numbers of the design data records DR are preferably normalized to lie between 0 (worst rank) and 1 (best rank).

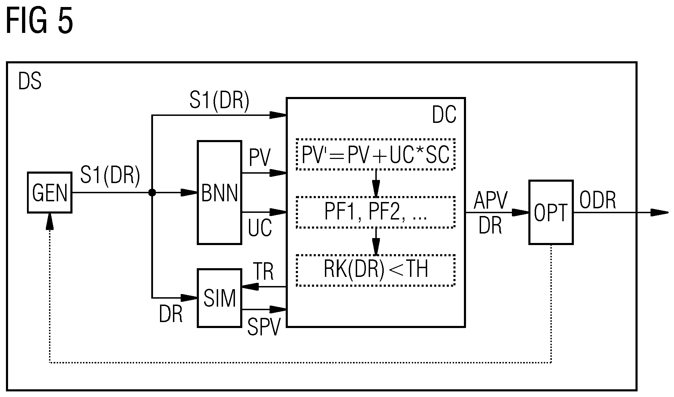

Figure 5 illustrates an optimization of a design of the product P by the design system DS. The latter comprises the Bayesian neural network BNN, which was trained as described above.

The design system DS further comprises a design generator GEN for generating a large first set S1 of synthetic design data records DR each specifying a different design variant of the product P. Moreover, the design system DS comprises a simulator SIM, a decision module DC, and an optimization module OPT.

From the design generator GEN the generated design data records DR of the first set S1 are fed into the trained Bayesian neural network BNN as input data and into the decision module DC. From a respective design data record DR, the trained Bayesian neural network BNN generates a corresponding group of predictive performance values PV, the group comprising for each of the performance quantities an estimated objective-specific predictive performance value quantifying that performance quantity. Furthermore, the Bayesian neural network BNN outputs for each of the objective-specific predictive performance values PV a corresponding objective-specific predictive uncertainty UC of that respective objective-specific predictive performance value.

The groups of predictive performance values PV and the corresponding predictive uncertainties UC are fed into the decision module DC. Depending on these groups of predictive performance values PV and the corresponding predictive uncertainties UC, the decisions module DC decides whether to run or to skip a simulation of a respective design variant by the simulator SIM.

The simulator SIM is enabled to carry out a detailed physical high-fidelity simulation of a design variant on the basis of a corresponding design data record DR. For that purpose, a design data record DR that is decided to be simulated, is transmitted from the design generator GEN to the simulator SIM. For performing such detailed physical simulations many efficient methods, e.g. finite-element methods, are known.

In the present case, the simulator SIM is particularly enabled to determine for each of the performance quantities an objective-specific simulated performance value quantifying the respective performance quantity.

Usually, a performance can be determined quite accurately by simulation. However, such accurate physical simulations often require considerable computation resources. An execution of trained machine learning modules, like BNN, on the other hand, normally requires much less computational effort. Hence, it appears advantageous to skip expensive simulations if the results of the machine learning module indicate a high probability that a respective design variant performs worse than other design variants and, therefore, is unlikely to be selected for manufacturing the product P.

So as not to overlook good but underestimated design candidates, the decision module DC modifies the predictive performance values PV of a respective group by the corresponding predictive uncertainties UC, resulting in modified predictive performance values PV'. According to the present embodiment, a respective predictive performance value PV is increased by the corresponding predictive uncertainty UC multiplied by a predefined scaling factor SC, e.g., according to PV' = PV + UC*SC. The scaling factor may be in the range of 0.5 to 5.

A resulting modified predictive performance value PV' may be regarded as a likely upper performance threshold for the corresponding performance quantity. The greater the scaling factor SC, the greater the probability that an actual performance does not exceed the modified predictive performance value PV' according to the predictive uncertainty UC. The scaling factor SC may be specifically chosen so that a modified predictive performance value PV' is not exceeded by an actual performance with a probability of 90%, 95%, 99%, 99.9%, etc.

Based on the modified predictive performance values PV' calculated for the first set S1, the decision module DC carries out a pareto optimization with the different performance quantities corresponding to the modified predictive performance values PV' as target quantities. As a result of the pareto optimization, a first pareto front PF1 of the first set S1 is determined by the decision module DC. After that the corresponding design data records DR of the first pareto front PF1 are assigned a first rank of 1.

As already mentioned in connection with figures 3 and 4 above, the pareto optimization is repeated with successively reduced sets of design data records. In particular, the design data records of the first pareto front PF1 are removed from the first set S1, resulting in a reduced set of design data records DR. For this reduced set the pareto optimal points are determined, which constitute a second pareto front PF2. The design data records of the second pareto front PF2 are then assigned a second rank of 2, which is obtained by increasing the previous rank number by 1. The preceding procedure is iterated until, e.g., each design data record DR of the first set S1 is ranked.

The ranking numbers of the design data records DR of the first set S1 are then normalized by the decision module DC to lie between 0 (worst rank) and 1 (best rank), resulting in normalized ranking values RK.

Depending on the normalized ranking values RK of the design data records DR the decision module DC decides whether a simulation of a respective design variant is carried out or skipped.

Such a ranking-based decision is expected to be particular advantageous in cases where many design variants are located near the pareto front. In such cases, all design variants with the same ranking are handled in the same way (i.e. are simulated or not) independently from an actual distance to the pareto front, thus entailing a more robust decision.

According to the present embodiment, the decision module DC compares a normalized ranking value RK of a respective design data record DR with a predefined threshold value TH and decides to skip the simulation if the normalized ranking value RK falls below that threshold value TH. Otherwise, the simulation is carried out. I.e. the simulation is skipped in cases where it appears to be unlikely that the respective design data record DR is competitive to other design data records. The threshold value TH may be chosen e.g. in the interval from 0.3 to 0.9.

As a consequence of deciding to run a simulation, the decision module DC generates a trigger signal TR and transmits it to the simulator SIM. The trigger signal TR causes the simulator SIM to simulate the design variant in question specified by the respective design data record DR. As a result of the simulation, the simulator SIM generates for each of the performance objectives a simulated objective-specific performance value SPV quantifying the corresponding objective-specific performance quantity of that design variant. The simulated performance values SPV are then transmitted from the simulator SIM to the decision module DC.

In order to obtain an overall performance measure for the design variant in question, the decision module DC then derives an aggregated performance value APV and allocates it to the corresponding design data record DR.

If the simulation is skipped, the decision module DC derives the aggregated performance value AGV from the corresponding group of predictive performance values PV. In particular, the aggregated performance value AGV of the design variant in question may be calculated as a weighted sum of those predicted performance values PV. The weights may be chosen in advance according to a priority or importance of a respective performance objective. Optionally, the corresponding predictive uncertainties UC may be also considered when deriving the aggregated performance value AGV. In this case the predictive uncertainties UC may be weighted by negative weights in the above-mentioned sum, so that design variants with uncertain performance values are penalized.

Otherwise, if the simulation is run, the decision module DC derives the aggregated performance value AGV from the simulated performance values SPV. In particular, the aggregated performance value AGV of the design variant in question may be calculated as a weighted sum of the simulated performance values SPV. The weights may be chosen in advance according to a priority or importance of a respective performance objective.

As already indicated above, the simulated performance values SPV are expected to be more accurate than the performance values PV predicted by the machine learning module BNN. Hence, the simulated performance values SPV may be stored in a database of the decision module DC in allocation to the corresponding design data record DR, so that the stored simulated performance values SPV can be used in future applications of the inventive method instead of less accurate predictive performance values PV. In particular, the ranking of design data records may be based on stored simulated performance values. Moreover, stored simulated performance values may be used to continue a training of the Bayesian neural network BNN. As the simulation results are usually quite accurate, the training status of the Bayesian neural network BNN may be improved in this way.

Finally, the design data records DR and the allocated aggregated performance values AGV are transmitted from the decision module DC to the optimization module OPT. Depending on the received aggregated performance values AGV, the optimization module OPT selects from the design data records DR one or more design data records which exhibit a highest or a particular high aggregated performance value AGV.

From the one or more selected design data records DR, the optimization module OPT takes or interpolates a performance-optimizing design data record ODR. The performance-optimizing design data record ODR is then output in order to control the production plant PP as described above.

According to an advantageous implementation, the optimization module OPT may influence the design generator GEN to drive the generation of the design data records DR in the direction of design variants with higher performance. This influence is indicated by a dotted arrow in figure 5.

## Claims

1. A computer-implemented method for controlling a production plant (PP) to manufacture a product (P), comprising:
a) providing a machine learning module (BNN) trained to generate from a design data record (DR) specifying a design variant of the product (P), a group of predictive performance values each quantifying a different performance quantity of that design variant,
b) providing a first set (S1) of design data records (DR) each specifying a different design variant of the product,
c) generating from the design data records (DR) of the first set (S1), in each case a corresponding group of predictive performance values (PV) by the machine learning module (BNN),
d) determining a pareto front (PF1) of the first set (S1) based on the corresponding groups (PV) and with the different performance quantities as target quantities,
e) assigning a first rank to the design data records (DR) of the pareto front (PF1),
f) removing the design data records of the pareto front (PF1) from the first set (S1), resulting in a reduced set (S2) of design data records (DR),
g) repeating steps d) to f) with the reduced set (S2) in place of the first set (S1) and with a reduced rank compared to the first rank, until a respective design data record (DR) is ranked,
h) depending on the rank of the respective design data record (DR), either running or skipping a simulation (SIM) of the design variant corresponding to the respective design data record (DR),
i) generating for the respective design data record (DR), an aggregated performance value (APV) derived from the simulation if the simulation (SIM) is run, or otherwise derived from said corresponding group of predictive performance values (PV),
j) depending on the aggregated performance values (PV), selecting from the first set (S1) of design data records (DR) a performance-optimizing design data record (ODR), and
k) outputting the selected design data record (ODR) for controlling the production plant (PP).

2. Method according to claim 1, wherein
the machine learning module (BNN) comprises or implements a Bayesian machine learning model, a Bayesian neural network and/or a Gaussian process model.

3. Method according to one of the preceding claims, further comprising
in case the simulation of a design variant is run
- determining by means of the simulation, a group of simulated performance values (SPV) quantifying the different performance quantities of said design variant, and
- using the group of simulated performance values (SPV) for ranking the corresponding design data record (DR).

4. Method according to one of the preceding claims, wherein
the machine learning module (BNN) generates, together with a respective predictive performance value (PV), a predictive uncertainty (UC) of the respective predictive performance value (PV), and
the predictive uncertainty (UC) is taken into account when deciding on running or skipping the simulation.

5. Method according to one of the preceding claims, wherein
the machine learning module (BNN) generates, together with a respective predictive performance value (PV), a predictive uncertainty (UC) of said predictive performance value (PV),
the respective predictive performance value (PV) is modified depending on the predictive uncertainty (UC), and
the pareto front (PF1) is determined based on the modified predictive performance values (PV').

6. Method according to one of the preceding claims, wherein
the ranks of the design data records (DR) are normalized to lie between a predefined lower bound corresponding to the lowest rank and a predefined upper bound corresponding to the highest rank, resulting in normalized ranking values (RK).

7. Method according to claim 6, wherein
the simulation of the design variant corresponding to a respective design data record (DR) is skipped if the normalized ranking value (RK) of said respective design data record (DR) falls below a predefined threshold value (TH).

8. Method according to one of the preceding claims, wherein
a training of the machine learning module (BNN) is continued by using simulated performance values (SPV) as training data.

9. A system (DS) for controlling a production plant (PP) to manufacture a product (P), the system (DS) comprising means for carrying out a method according to one of the preceding claims.

10. A computer program product for controlling a production plant (PP) to manufacture a product (P), the computer program product comprising instructions which, when the program is executed by a computer, cause the computer to carry out a method according to one of the claims 1 to 8.

11. A non-transient computer readable storage medium storing a computer program product according to claim 10.
